**Europäisches Patentamt**

**European Patent Office**

**Office européen des brevets**

(19)

(11) **EP 1 419 845 A1**

(12) **EUROPÄISCHE PATENTANMELDUNG**

| | |
|---|---|
| (43) Veröffentlichungstag:<br>**19.05.2004  Patentblatt 2004/21** | (51) Int Cl.7: **B23K 20/00**, H01L 21/66 |

(21) Anmeldenummer: **02079593.6**

(22) Anmeldetag: **16.10.2002**

(84) Benannte Vertragsstaaten:
**AT BE BG CH CY CZ DE DK EE ES FI FR GB GR
IE IT LI LU MC NL PT SE SK TR**
Benannte Erstreckungsstaaten:
**AL LT LV MK RO SI**

(71) Anmelder: **Esec Trading S.A.
6330 Cham (CH)**

(72) Erfinder: **Mayer, Michael, Dr.
6345 Neuheim (CH)**

(74) Vertreter: **Falk, Urs, Dr.
Patentanwaltsbüro Dr. Urs Falk,
Eichholzweg 9A
6312 Steinhausen (CH)**

Bemerkungen:
Ein Antrag gemäss Regel 88 EPÜ auf Berichtigung
der Zeichnungen liegt vor. Über diesen Antrag wird
im Laufe des Verfahrens vor der Prüfungsabteilung
eine Entscheidung getroffen werden (Richtlinien für
die Prüfung im EPA, A-V, 3.).

(54) **Verfahren für die Bestimmung optimaler Bondparameter beim Bonden mit einem Wire Bonder**

(57)    Optimale Bondparameter für eine Bondkraft $F_B$ und eine Ultraschallgrösse $P_B$ und, fakultativ, mindestens einen weiteren Bondparameter $G_B$ eines Wire Bonders für das Ball-bonden lassen sich ermitteln mittels eines Verfahrens, bei dem eine vorbestimmte Anzahl Bondzyklen durchgeführt wird, wobei die zu optimierenden Bondparameter in je einem vorbestimmten Bereich variiert werden, wobei bei jedem Bondzyklus n nach der Befestigung der Drahtkugel auf dem Anschlusspunkt (4) des Halbleiterchips (5) folgende Schritte durchgeführt werden:

a) Anlegen einer vorbestimmten Bondkraft $F_{B1}$,
b) Bewegen der Kapillare (1) aus der Bondposition in eine vorbestimmte horizontale Richtung, wobei der durch den die Kapillare (1) bewegenden Antrieb fließende Strom $I_{B,n}$ überwacht wird,
c) Stoppen der Bewegung der Kapillare (1), sobald der Strom $I_{B,n}$ abnimmt,
d) Bestimmen des Maximums des Stromes $I_{B,n,max}$ ($F_{B,n}$, $P_{B,n}$, $G_{B,n}$) aus dem während der Schritte b) und c) ermittelten Verlauf des Stromes $I_{B,n}(t)$,
e) Bewegen der Kapillare (1) an die Bondposition,
f) Befestigen der Drahtkugel auf dem Anschlusspunkt (4) des Halbleiterchips (5),

und wobei aus den bei den n Bondzyklen ermittelten Werten $I_{B,n,max}$ ($F_{B,n}$, $P_n$, $G_n$) diejenigen Werte der Bondkraft $F_B$, der Ultraschallgrösse $P_B$ und des gegebenenfalls mindestens einen weiteren Bondparameters $G_B$ als optimale Bondparameter bestimmt werden, für die der Strom $I_{B,n,max}$ ($F_{B,n}$, $P_n$, $G_n$) ein Maximum erreicht.

Fig. 2B

**Beschreibung**

Die Erfindung betrifft ein Verfahren für die Bestimmung optimaler Bondparameter beim Bonden mit einem Wire Bonder der im Oberbegriff des Anspruchs 1 genannten Art.

Ein Wire Bonder ist eine Maschine, mit der Halbleiterchips nach deren Montage auf einem Substrat verdrahtet werden. Der Wire Bonder weist eine Kapillare auf, die an der Spitze eines Horns eingespannt ist. Die Kapillare dient zum Befestigen des Drahts auf einem Anschlusspunkt des Halbleiterchips und auf einem Anschlusspunkt des Substrats sowie zur Drahtführung zwischen den beiden Anschlusspunkten. Bei der Herstellung der Drahtverbindung zwischen dem Anschlusspunkt des Halbleiterchips und dem Anschlusspunkt des Substrats wird das aus der Kapillare ragende Drahtende zunächst zu einer Kugel geschmolzen. Anschliessend wird die Drahtkugel auf dem Anschlusspunkt des Halbleiterchips mittels Druck und Ultraschall befestigt. Dabei wird das Horn von einem Ultraschallgeber mit Ultraschall beaufschlagt. Diesen Prozess nennt man Ballbonden. Dann wird der Draht auf die benötigte Drahtlänge durchgezogen, zu einer Drahtbrücke geformt und auf dem Anschlusspunkt des Substrats verschweisst. Diesen letzten Prozessteil nennt man Wedge-bonden. Nach dem Befestigen des Drahts auf dem Anschlusspunkt des Substrats wird der Draht abgerissen und der nächste Bondzyklus kann beginnen.

Das Ball-bonden wie auch das Wedge-bonden werden von verschiedenen Faktoren beeinflusst. Um Bondverbindungen von vorbestimmter Qualität zu erzielen, müssen für einen bestimmten Prozess die passenden Werte mehrerer physikalischer und/oder technischer Parameter eruiert werden. Beispiele solcher Parameter sind:

- die Bondkraft, das ist die Normalkraft, die die Kapillare während des Bondvorgangs auf die Bondkugel bzw. den Anschlusspunkt des Halbleiterchips ausübt,
- ein hierin als Ultraschallgrösse P bezeichneter Parameter, der die Beaufschlagung des Ultraschallgebers mit Ultraschall steuert. Die Ultraschallgrösse ist z.B. die Amplitude des Wechselstroms, der durch den Ultraschallgeber des Horns fliesst, oder die Amplitude der Wechselspannung, die an den Ultraschallgeber angelegt wird, oder die Leistung oder eine andere Grösse,
- eine hierin als Ultraschallzeit T bezeichnete Zeitdauer, die angibt, wie lange der Ultraschallgeber mit der Ultraschallgrösse P beaufschlagt wird,
- die Auftreffgeschwindigkeit der Kapillare auf den Anschlusspunkt,
- ein binärer Parameter, der angibt, ob der Ultraschallgeber bereits vor dem Auftreffen der Kapillare auf dem Anschlusspunkt mit der Ultraschallgrösse beaufschlagt wird.

Für die Bestimmung der Bondqualität im Sinne einer Qualitätskontrolle wie auch für die Ermittlung optimaler Bondparameter werden heutzutage vor allem zwei Methoden verwendet, nämlich

a) ein sogenannter Pull-Test, bei dem die Kraft gemessen wird, bei der der Bond vom Halbleiterchip bzw. vom Substrat abreißt, wenn der Bond in senkrechter Richtung zur Oberfläche des Halbleiterchips bzw. Substrats gezogen wird, und

b) ein sogenannter Shear-Test, bei dem die Kraft gemessen wird, bei der der Bond vom Halbleiterchip bzw. vom Substrat abreißt, wenn der Bond mittels eines Werkzeugs parallel zur Oberfläche des Halbleiterchips bzw. Substrats weggedrückt wird.

Diese Tests werden normalerweise mit speziell für diese Anwendung entwickelten Geräten durchgeführt. Aus dem Patent US 5 894 981 ist jedoch ein Wire Bonder bekannt, der für die Durchführung eines Pull-Tests eingerichtet ist. Der Pull-Test lässt sich allerdings nur für Wedge Bonds durchführen.

Der Erfindung liegt die Aufgabe zugrunde, ein Verfahren für die einfache Bestimmung optimaler Bondparameter sowohl für das Ball-bonden wie für das Wedge-bonden zu entwickeln.

Die Erfindung besteht in den in den Ansprüchen 1 und 2 angegebenen Merkmalen.

Optimale Bondparameter für eine Bondkraft $F_B$ und eine Ultraschallgrösse $P_B$ und, fakultativ, mindestens einen weiteren Bondparameter $G_B$ eines Wire Bonders für das Ball-bonden lassen sich erfindungsgemäss ermitteln mittels eines Verfahrens mit den folgenden Schritten:

Durchführen einer Anzahl Bondzyklen von n = 1 bis k, wobei die Bondkraft $F_B$ und die Ultraschallgrösse $P_B$ und, gegebenenfalls, der mindestens eine weitere Bondparameter $G_B$ in je einem vorbestimmten Bereich in diskreten Schritten variiert werden, wobei bei jedem Bondzyklus eine Drahtverbindung zwischen einem Anschlusspunkt eines Halbleiterchips und einem Anschlusspunkt eines Substrats hergestellt wird, indem ein aus einer Kapillare ragendes Drahtende zu einer Kugel geschmolzen und anschliessend die Drahtkugel in einer ersten Bondposition auf dem Anschlusspunkt des Halbleiterchips befestigt wird, dann der Draht auf die benötigte Drahtlänge durchgezogen, zu einer Drahtbrücke geformt und in einer zweiten Bondposition auf dem Anschlusspunkt des Substrats befestigt wird, und wobei die Bondkraft $F_B$, die Ultraschallgrösse $P_B$ und, gegebenenfalls, der mindestens eine weitere Bondparameter $G_B$ in je einem vorbestimmten Bereich in diskreten Schritten variiert werden, und wobei bei jedem Bondzyklus n nach der Befestigung der Drahtkugel auf dem Anschlusspunkt des Halbleiterchips folgende Schritte durchgeführt werden:

a) Anlegen einer vorbestimmten Bondkraft $F_{B1}$,

b) Bewegen der Kapillare aus der Bondposition in eine vorbestimmte horizontale Richtung, wobei der durch den die Kapillare bewegenden Antrieb fließende Strom $I_{B,n}$ überwacht wird,

c) Stoppen der Bewegung der Kapillare, sobald der Strom $I_{B,n}$ abnimmt,

d) Bestimmen des Maximums des Stromes $I_{B,n,max}$ ($F_{B,n}$, $P_{B,n}$, $G_{B,n}$) aus dem während der Schritte b) und c) ermittelten Verlauf des Stromes $I_{B,n}$ ($F_{B,n}$, $P_{B,n}$, $G_{B,n}$, t), wobei die Größen $F_{B,n}$, $P_{B,n}$ und $G_{B,n}$ die beim Bondzyklus n eingestellten Werte der Bondkraft $F_B$, der Ultraschallgrösse $P_B$ und, gegebenenfalls, des mindestens einen weiteren Bondparameters $G_B$ sind, und mit dem Parameter t die Zeit bezeichnet ist,

e) Bewegen der Kapillare an die Bondposition,

f) Befestigen der Drahtkugel auf dem Anschlusspunkt des Halbleiterchips,

und wobei aus den bei den n Bondzyklen ermittelten Werten $I_{B,n,max}$ ($F_{B,n}$, $P_n$, $G_n$) diejenigen Werte der Bondkraft $F_B$, der Ultraschallgrösse $P_B$ und des gegebenenfalls mindestens einen weiteren Bondparameters $G_B$ als optimale Bondparameter bestimmt werden, für die der Strom $I_{B,n,max}$ ($F_{B,n}$, $P_n$, $G_n$) ein Maximum erreicht. Bei dieser Bestimmung können allenfalls übliche Methoden der Statistik wie beispielsweise Interpolation angewendet werden.

Die Bondkraft $F_{B1}$ ist bei allen Schertests die gleiche. Sie wird in der Regel so klein wie möglich eingestellt, damit das Resultat des Schertests nicht durch Reibungskräfte verfälscht wird, die zwischen der Unterseite des Balls und dem Anschlusspunkt wirken. Typischerweise beträgt die Bondkraft $F_{B1}$ etwa 50mN.

Die Schritte e und f können allenfalls entfallen, da sie nur dazu dienen, eine Störung der nachfolgenden Bondzyklen zu vermeiden.

Optimale Bondparameter für die Bondkraft $F_W$, die Ultraschallgrösse $P_W$ und, fakultativ, den mindestens einen weiteren Bondparameter $G_W$ eines Wire Bonders für das Wedge-bonden lassen sich ermitteln mittels eines analogen Verfahrens, das für jeden Bondzyklus andere Werte der Parameter $F_W$, $P_W$ und, gegebenenfalls $G_W$ vorsieht und bei dem bei jedem Bondzyklus n nach der Befestigung des Drahts auf dem Anschlusspunkt des Substrats folgende Schritte durchgeführt werden:

a) Anlegen einer vorbestimmten Bondkraft $F_{W1}$,

b) Bewegen der Kapillare aus der Bondposition in eine vorbestimmte horizontale Richtung, wobei der durch den die Kapillare bewegenden Antrieb fließende Strom $I_{W,n}$ überwacht wird,

c) Stoppen der Bewegung der Kapillare, sobald der Strom $I_{W,n}$ abnimmt,

d) Bestimmen des Maximums des Stromes $I_{W,n,max}$ ($F_{W,n}$, $P_{W,n}$, $G_{W,n}$) aus dem während der Schritte b) und c) ermittelten Verlauf des Stromes $I_{W,n}$ ($F_{W,n}$, $P_{W,n}$, $G_{W,n}$, t), wobei die Größen $F_{W,n}$, $P_{W,n}$ und $G_{W,n}$ die beim Bondzyklus n eingestellten Werte der Bondkraft $F_W$, der Ultraschallgrösse $P_W$ und, gegebenenfalls, des mindestens einen weiteren Bondparameters $G_W$ sind,

e) Bewegen der Kapillare an die Bondposition,

f) Befestigen des Drahts auf dem Anschlusspunkt des Substrats,

und bei dem aus den bei den n Bondzyklen ermittelten Werten $I_{W,n,max}$ ($F_{W,n}$, $P_{W,n}$, $G_{W,n}$) diejenigen Werte der Bondkraft $F_W$, der Ultraschallgrösse $P_W$ und des gegebenenfalls mindestens einen weiteren Bondparameters $G_W$ als optimale Bondparameter bestimmt werden, für die der Strom $I_{W,n,max}$ ($F_{W,n}$, $P_{W,n}$, $G_{W,n}$) ein Maximum erreicht.

Die Bondkraft $F_{W1}$ ist bei allen Schertests die gleiche und wird in der Regel so klein wie möglich eingestellt.

Bei diesem Verfahren wird mit dem Strom $I_{B,n,max}$ bei jedem Bondzyklus ein Wert ermittelt, der proportional zur Schubfliess-Spannung und somit ein Maß für die Scherfestigkeit des Ball-Bonds auf dem Halbleiterchip ist und mit dem Strom $I_{W,n,max}$ ein Wert, der ein Maß für die Scherfestigkeit des Wedge-Bonds auf dem Substrat ist.

Es sei hier angemerkt, dass die Zahl der Bondparameter, die variiert werden, beim Ball-Bonden und beim Wedge-Bonden verschieden sein können.

Des Weiteren sei hier angemerkt, dass sich das erfindungsgemässe Verfahren für die Implementierung auf Wire Bondern unterschiedlicher Konstruktion eignet. Es gibt Wire Bonder, die einen Antrieb für die Bewegung des Horns mit der Kapillare in einer x-Richtung und einen Antrieb für die Bewegung in einer zur x-Richtung orthogonalen y-Richtung aufweisen. Aus der europäischen Patentanmeldung EP 1098356 ist ein Wire Bonder bekannt mit einem Antrieb für die Bewegung des Horns und der Kapillare in einer vorbestimmten Richtung und einem zweiten Antrieb für eine Drehbewegung des Horns und der Kapillare um eine Drehachse.

Nachfolgend wird ein Ausführungsbeispiel der Erfindung anhand der Zeichnung näher erläutert.

Es zeigen:

Fig. 1A bis 1E     verschiedene Phasen eines einfachen Bondzyklus,

Fig. 2A bis 2D     verschiedene Momentaufnahmen während der Bestimmung der Scherfestigkeit eines Ball-Bonds,

Fig. 3A bis 3D     verschiedene Momentaufnahmen während der Bestimmung der Scherfestigkeit eines Wedge-Bonds,

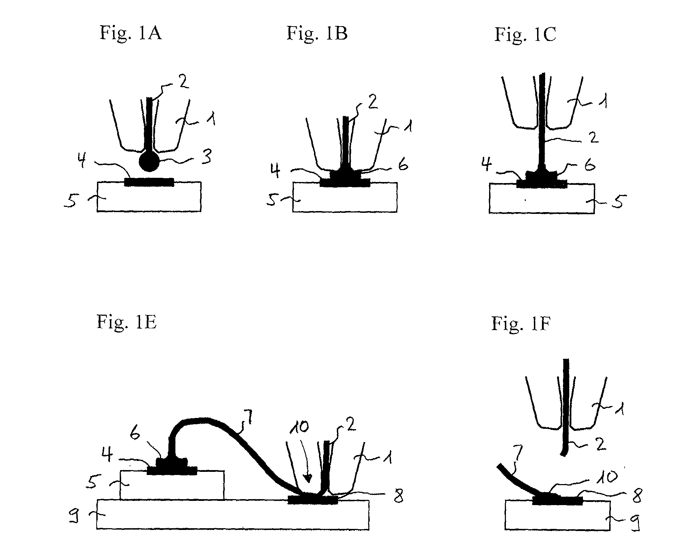

Die Fig. 1A bis 1E zeigen die verschiedenen Phasen eines einfachen Bondzyklus:

A) An der Spitze einer Kapillare 1 wird ein aus der Kapillare 1 herausragendes Ende eines Drahts 2 zu einer Drahtkugel 3 geformt (Fig. 1A).

B) Die Drahtkugel 3 wird auf einen ersten Anschlusspunkt 4 eines Halbleiterchips 5 gebondet (Ball 6) (Fig. 1B).

C) Die Kapillare 1 wird angehoben und der Draht 2 auf die benötigte Länge ausgezogen (Fig. 1C).

D) Die Kapillare 1 fährt eine vorbestimmte Bahnkurve, wobei der Draht 2 zu einer Drahtbrücke 7 geformt wird.

E) Der Draht 2 wird auf einen Anschlusspunkt 8 eines Substrats 9 gebondet (Wedge 10) (Fig. 1D)

F) Die Kapillare 1 wird angehoben, wobei der Draht 2 beim Wedge-Bond 10 abreißt und ein kurzes Stück des Drahts 2 aus der Kapillare 1 herausragt (Fig. 1E), so dass anschliessend der nächste Bondzyklus durchgeführt werden kann.

Dieser Bondzyklus stellt nur eine einfache Variante dar, die für das Verständnis der vorliegenden Erfindung ausreicht. Aus der Fach- und Patentliteratur sind aber eine Vielzahl von Bondzyklen bekannt, bei denen die einzelnen Schritte, insbesondere die Schritte c) und d) weiter verfeinert worden sind. Das Substrat 9 kann selbst auch ein Halbleiterchip sein, beispielsweise in einem Multichip Modul.

Für die Bestimmung optimaler Bondparameter für die Bondkraft F, eine Ultraschallgrösse P und, fakultativ, mindestens einen weiteren Bondparameter G eines Wire Bonders für das Ball-bonden wie für das Wedge-Bonden werden eine Anzahl von n = 1 bis k Bondzyklen durchgeführt, wobei die Bondkraft $F_B$ bzw. $F_W$, die Ultraschallgrösse $P_B$ bzw. $P_W$ und, gegebenenfalls, der mindestens eine weitere Bondparameter $G_B$ bzw. $G_W$ in je einem vorbestimmten Bereich in diskreten Schritten variiert werden. Bei jedem Bondzyklus n werden nach der Befestigung der Drahtkugel 3 auf dem Anschlusspunkt 4 des Halbleiterchips 5, d.h. nach dem Schritt B und vor dem Schritt C, folgende Schritte durchgeführt:

B.a) Anlegen einer vorbestimmten Bondkraft $F_{B1}$,

B.b) Bewegen der Kapillare 1 aus der Bondposition in eine vorbestimmte horizontale Richtung, wobei der durch den die Kapillare 1 bewegenden Antrieb fließende Strom $I_{B,n}(t)$ überwacht wird (t bezeichnet die Zeit),

B.c) Stoppen der Bewegung der Kapillare 1, sobald der Strom $I_{B,n}(t)$ abnimmt,

B.d) Bestimmen des Maximums des Stromes $I_{B,n,max}$ ($F_{B,n}$, $P_{B,n}$, $G_{B,n}$) aus dem während der Schritte b) und c) ermittelten zeitlichen Verlauf des Stromes $I_{B,n}(t)$, wobei die Größen $F_{B,n}$, $P_{B,n}$ und $G_{B,n}$ die beim Bondzyklus n eingestellten Werte der Bondkraft $F_B$, der Ultraschallgrösse $P_B$ und, gegebenenfalls, des mindestens einen weiteren Bondparameters $G_B$ sind,

B.e) Bewegen der Kapillare 1 an die Bondposition,

B.f) Befestigen der Drahtkugel 3 auf dem Anschlusspunkt 4 des Halbleiterchips 5.

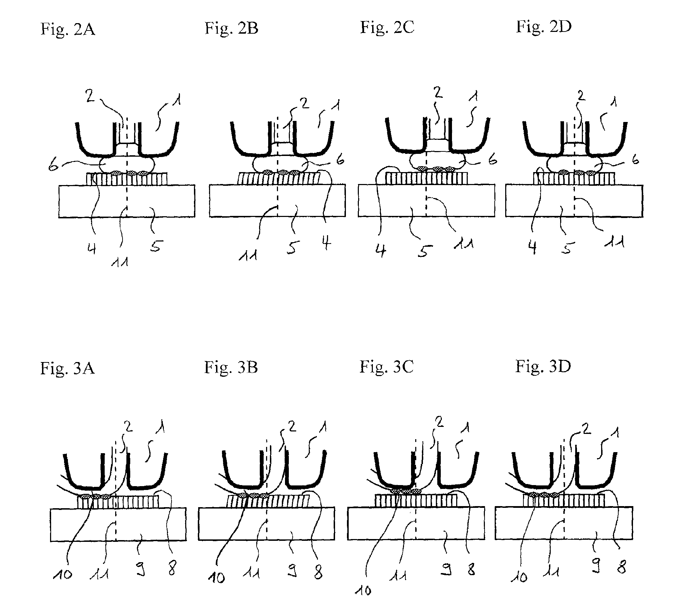

Diese Schritte werden nun anhand der Fig. 2A bis 2D näher illustriert. Die Bondposition ist mit einer gestrichelten Linie 11 dargestellt, damit die Lage der Kapillare 1 zur Bondposition ersichtlich ist. Die Fig. 2A zeigt die Situation während des Schrittes B, wenn die Drahtkugel 3 auf den Anschlusspunkt 4 des Halbleiterchips 5 gebondet wird, wobei der Ball-Bond 6 entsteht. Das Bonden der Drahtkugel 3 erfolgt mit den Parametern: Bondkraft $F_{B,n}$, Ultraschall $P_{B,n}$ und gegebenenfalls, des mindestens einen weiteren Bondparameters $G_{B,n}$. Die Kapillare 1 befindet sich in der Bondposition über dem Anschlusspunkt 4.

Die Fig. 2B zeigt die Situation während des Schrittes B.b. Das nicht dargestellte Horn, an dessen Spitze die Kapillare 1 eingespannt ist, wird in einer horizontalen Richtung verschoben oder um eine vertikale Achse gedreht. Gleichzeitig wird der Strom I überwacht, der durch den Antrieb fließt, der das Horn verschiebt bzw. dreht. Die Spitze der Kapillare 1 drückt dabei gegen den auf dem Anschlusspunkt 4 des Halbleiterchips 5 befestigten Ball. Der Ball und der Anschlusspunkt 4 können dabei leicht verformt werden, so dass die Kapillare 1 ein wenig aus der Bondposition wegbewegt wird. Der am Anschlusspunkt 4 haftende Ball hindert nun aber die Kapillare 1 und somit auch das Horn an der Ausführung der gewünschten Bewegung. Die von der Kapillare 1 auf den Ball in horizontaler Richtung ausgeübte Kraft nimmt kontinuierlich zu, bis sich der Ball schliesslich vom Anschlusspunkt 4 löst. Die Kapillare 1 kann nun der Bewegung des Horns folgen, so dass der durch den Antrieb fließende Strom schnell abfällt, worauf die Bewegung der Kapillare 1 im Schritt B.c sofort gestoppt wird. Diese Situation ist in der Fig. 2C gezeigt. Die Kapillare 1 wird später im Schritt B.e in die Bondposition zurückgebracht und im Schritt B.f wird der Ball nochmals auf dem Anschlusspunkt 4 des Halbleiterchips 5 befestigt. Es werden nun zwei Methoden erläutert, wie der Schritt B.b durchgeführt werden kann:

Gemäß der ersten Methode wird der Wire Bonder angewiesen, die Spitze der Kapillare 1 aus ihrer Bondposition in eine neue Position zu verschieben. Dies erfolgt mittels eines Reglers, der eine Positionsabweichung in einen Befehl für den durch den entsprechenden Antrieb fließenden Strom 1 umsetzt. Da die Kapillare 1 durch den Ball an der Ausführung der Bewegung zunächst gehindert wird, ändert sich die Ist-Position der Kapillare 1 nicht, so dass die Differenz zwischen der Soll-Position und der Ist-Position bestehen bleibt. Dies führt dazu, dass der Regler den Strom I kontinuierlich erhöht. Der Strom I(t) wird laufend erfasst und als eine Reihe von m Stromwerten $I_1(t)$, $I_2(t+\Delta t)$, ..., $I_{m+1}(t+m^*\Delta t)$ gespeichert, wobei die Größe At eine vorbestimmte Zeitdauer bezeichnet. Wenn der Stromwert $I_{m+1}$ kleiner als der vorangegangene Stromwert $I_m$ ist, bedeutet dies, dass sich die Kapillare 1 bewegen kann, weil sich der Ball nun vom Anschlusspunkt 4 des Halbleiterchips 5 löst, so dass die Differenz zwischen der Soll-Position und der Ist-Position kleiner wird. Es wird deshalb im Schritt B.d der Wert

$$I_{B,n,max} \, (F_{B,n}, P_{B,n}, G_{B,n}) = I_m$$

gespeichert.

Gemäß der zweiten Methode wird der Wire Bonder angewiesen, den durch den Antrieb der Kapillare 1 fließenden Strom I kontinuierlich zu erhöhen und gleichzeitig die Position des Horns bzw. der Kapillare 1 zu überwachen. Der Strom I wird also in Schritten $\Delta I$ laufend erhöht: $I_{m+1}=I_m+\Delta I$. Nach jeder Stromerhöhung wird die Position des Horns bzw. der Kapillare 1 überprüft. Sobald sich die Position um mehr als einen vorbestimmten Wert geändert hat, bedeutet dies, dass sich der Ball nun vom Anschlusspunkt 4 des Halbleiterchips 5 löst. Es wird deshalb im Schritt B.d der Wert $I_{B,n,max}$ $(F_{B,n}, P_{B,n}, G_{B,n}) = I_m$ gespeichert.

Analog werden nach der Befestigung des Drahts 2 auf dem Anschlusspunkt 8 des Substrats 9, d. h. nach dem Schritt E und vor dem Schritt F, folgende Schritte durchgeführt:

E.a) Anlegen einer vorbestimmten Bondkraft $F_{W2}$,
E.b) Bewegen der Kapillare 1 aus der Bondposition in eine vorbestimmte horizontale Richtung, wobei der durch den die Kapillare 1 bewegenden Antrieb fließende Strom $I_{W,n}(t)$ überwacht wird,
E.c) Stoppen der Bewegung der Kapillare 1, sobald der Strom $I_{W,n}(t)$ abnimmt,
E.d) Bestimmen des Maximums des Stromes $I_{W,n,max}$ $(F_{W,n}, P_{W,n}, G_{W,n})$ aus dem während der Schritte b) und c) ermittelten Verlauf des Stromes $I_{W,n}(t)$, wobei die Größen $F_{W,n}$, $P_{W,n}$ und $G_{W,n}$ die beim Bondzyklus n eingestellten Werte der Bondkraft $F_W$, der Ultraschallgrösse $P_W$ und, gegebenenfalls, des mindestens einen weiteren Bondparameters $G_W$ sind,
E.e) Bewegen der Kapillare 1 an die Bondposition,
E.f) Befestigen des Drahts 2 auf dem Anschlusspunkt 8 des Substrats 9.

Die Fig. 3A bis 3D zeigen vier Momentaufnahmen, die das Wedge-Bonden betreffen. Die Fig. 3A zeigt die Situation während des Schrittes E, wenn der Draht 2 auf den Anschlusspunkt 8 des Substrats 9 gebondet wird. Das Bonden des Drahts 2 erfolgt mit den Parametern: Bondkraft $F_{W,n}$, Ultraschall $P_{W,n}$ und gegebenenfalls, des mindestens einen weiteren Bondparameters $G_{W,n}$.

Die Fig. 3B zeigt die Situation während des Schrittes E.b. Das nicht dargestellte Horn, an dessen Spitze die Kapillare 1 eingespannt ist, wird in einer horizontalen Richtung verschoben oder um eine vertikale Achse gedreht. Gleichzeitig wird der Strom I überwacht, der durch den Antrieb fließt, der das Horn verschiebt bzw. dreht. Die Spitze der Kapillare 1 drückt dabei gegen den auf dem Anschlusspunkt 8 des Substrats 9 als Wedge 10 befestigten Draht 2, der die Kapillare 1 und somit auch das Horn an der Ausführung der gewünschten Bewegung hindert. Die von der Kapillare 1 auf den Wedge 10 in horizontaler Richtung ausgeübte Kraft nimmt kontinuierlich zu, bis sich der Wedge 10 schliesslich vom Anschlusspunkt 8 löst. Die Kapillare 1 kann nun der Bewegung des Horns folgen, so dass der durch den Antrieb fließende Strom schnell abfällt, worauf die Bewegung der Kapillare 1 im Schritt E.c sofort gestoppt wird. Diese Situation ist in der Fig. 3C gezeigt. Die Kapillare 1 wird später im Schritt E.e in die Bondposition zurückgebracht und im Schritt B.f wird der Wedge 10 nochmals auf dem Anschlusspunkt 8 des Substrats 9 befestigt.

Nach der Durchführung der n Bondzyklen werden aus den ermittelten Werten $I_{B,n,max}$ $(F_{B,n}, P_n, G_n)$ diejenigen Werte der Bondkraft $F_B$, der Ultraschallgrösse $P_B$ und des gegebenenfalls mindestens einen weiteren Bondparameters $G_B$ als optimale Bondparameter für das Ball-Bonden bestimmt, für die der Strom $I_{B,n,max}$ $(F_{B,n}, P_n, G_n)$ ein Maximum erreicht. Ebenso werden aus den ermittelten Werten $I_{W,n,max}$ $(F_{W,n}, P_{W,n}, G_{W,n})$ diejenigen Werte der Bondkraft $F_W$, der Ultraschallgrösse $P_W$ und des gegebenenfalls mindestens einen weiteren Bondparameters $G_W$ als optimale Bondparameter für das Wedge-Bonden bestimmt, für die der Strom $I_{W,n,max}$ $(F_{W,n}, P_{W,n}, G_{W,n})$ ein Maximum erreicht.

Die Spitze der Kapillare 1 wird während der Schritte B.b bzw. E.b nur wenige Mikrometer, beispielsweise 5 bis 10 Mikrometer, bewegt. Diese Bewegung reicht aus, dass sich der Ball bzw. Wedge löst. Es ist deshalb vorzugsweise vorgesehen, den Schertest abzubrechen, wenn sich die Spitze der Kapillare 1 um mehr als eine vorbestimmte Distanz bewegt hat, ohne dass der durch den Antrieb fließende Strom abgenommen hat.

Die Schritte B.e und B.f sowie E.e und E.f dienen dazu, den losgelösten Ball bzw. Wedge wieder am entsprechenden Anschlusspunkt zu befestigen, damit die nachfolgenden Bondzyklen ohne Störung durchgeführt werden können. Die Schritte B.e und E.e können allenfalls entfallen.

**Patentansprüche**

1. Verfahren für die Bestimmung optimaler Bondparameter für eine Bondkraft $F_B$ und eine Ultraschallgrösse $P_B$ und, fakultativ, mindestens einen weiteren Bondparameter $G_B$ eines Wire Bonders für einen Bondprozess, wobei für diese Bestimmung eine Anzahl Bondzyklen durchgeführt werden, wobei bei jedem Bondzyklus eine Drahtverbindung zwischen einem Anschlusspunkt (4) eines Halbleiterchips (5) und einem Anschlusspunkt (8) eines Substrats (9) hergestellt wird, indem ein aus einer Kapillare (1) ragendes Drahtende zu einer Kugel (3) geschmolzen und anschliessend die Drahtkugel (3) in einer Bondposition auf dem Anschlusspunkt (4) des Halbleiterchips (5) befestigt wird, dann der Draht (2) auf die benötigte Drahtlänge durchgezogen, zu einer Drahtbrücke geformt und auf dem Anschlusspunkt (8) des Substrats (9) befestigt wird, und wobei die Bondkraft $F_B$, die Ultraschallgrösse $P_B$ und, gegebenenfalls, der mindestens eine weitere Bondparameter $G_B$ in je einem vorbestimmten Bereich in diskreten Schritten variiert werden, **dadurch gekennzeichnet, dass** bei jedem Bondzyklus n nach der Befestigung der Drahtkugel (3) auf dem Anschlusspunkt (4) des Halbleiterchips (5) folgende Schritte durchgeführt werden:

 a) Anlegen einer vorbestimmten Bondkraft $F_{B1}$,
 b) Bewegen der Kapillare (1) aus der Bondposition in einer vorbestimmten Richtung, wobei der durch den die Kapillare (1) bewegenden Antrieb fließende Strom $I_n(t)$ im Verlauf der Zeit t überwacht wird,
 c) Stoppen der Bewegung der Kapillare (1), sobald der Strom $I_n(t)$ abnimmt,
 d) Bestimmen des Maximums des Stromes $I_{n,max}$ ($F_{B,n}$, $P_{B,n}$, $G_{B,n}$) aus dem während der Schritte b) und c) ermittelten Verlauf des Stromes $I_n(t)$, wobei die Größen $F_{B,n}$, $P_{B,n}$ und $G_{B,n}$ die beim Bondzyklus n eingestellten Werte der Bondkraft $F_B$, der Ultraschallgrösse $P_B$ und, gegebenenfalls, des mindestens einen weiteren Bondparameters $G_B$ sind,

und dass aus den bei den n Bondvorgängen ermittelten Werten $I_{n,max}$ ($F_{B,n}$, $P_{B,n}$, $G_{B,n}$) diejenigen Werte der Bondkraft $F_B$, der Ultraschallgrösse $P_B$ und des gegebenenfalls mindestens einen weiteren Bondparameters $G_B$ als optimale Bondparameter bestimmt werden, für die der Strom $I_{n,max}$ ($F_{B,n}$, $P_{B,n}$, $G_{B,n}$) ein Maximum erreicht.

**2.** Verfahren für die Bestimmung optimaler Bondparameter für eine Bondkraft $F_W$ und eine Ultraschallgrösse $P_W$ und, fakultativ, mindestens einen weiteren Bondparameter $G_W$ eines Wire Bonders für einen Bondprozess, wobei für diese Bestimmung eine Anzahl Bondzyklen durchgeführt werden, wobei bei jedem Bondzyklus eine Drahtverbindung zwischen einem Anschlusspunkt (4) eines Halbleiterchips (5) und einem Anschlusspunkt (8) eines Substrats (9) hergestellt wird, indem ein aus einer Kapillare (1) ragendes Drahtende zu einer Kugel (3) geschmolzen und anschliessend die Drahtkugel (3) in einer Bondposition auf dem Anschlusspunkt (4) des Halbleiterchips (5) befestigt wird, dann der Draht (2) auf die benötigte Drahtlänge durchgezogen, zu einer Drahtbrücke geformt und auf dem Anschlusspunkt (8) des Substrats (9) befestigt wird, und wobei die Bondkraft Fw, die Ultraschallgrösse $P_W$ und, gegebenenfalls, der mindestens eine weitere Bondparameter Gw in je einem vorbestimmten Bereich in diskreten Schritten variiert werden, **dadurch gekennzeichnet, dass** bei jedem Bondzyklus n nach der Befestigung des Drahtes (2) auf dem Anschlusspunkt (8) des Substrats (9) folgende Schritte durchgeführt werden:

 a) Anlegen einer vorbestimmten Bondkraft $F_{W1}$,
 b) Bewegen der Kapillare (1) aus der Bondposition in einer vorbestimmten Richtung, wobei der durch den die Kapillare (1) bewegenden Antrieb fließende Strom $I_n(t)$ im Verlauf der Zeit t überwacht wird,
 c) Stoppen der Bewegung der Kapillare (1), sobald der Strom $I_n(t)$ abnimmt,
 d) Bestimmen des Maximums des Stromes $I_{n,max}$ ($F_{W,n}$, $P_{W,n}$, $G_{W,n}$) aus dem während der Schritte b) und c) ermittelten Verlauf des Stromes $I_n(t)$, wobei die Größen $F_{B,n}$, $P_{W,n}$ und $G_{W,n}$ die beim Bondzyklus n eingestellten Werte der Bondkraft $F_W$, der Ultraschallgrösse $P_W$ und, gegebenenfalls, des mindestens einen weiteren Bondparameters $G_W$ sind,

und dass aus den bei den n Bondvorgängen ermittelten Werten $I_{n,max}$ ($F_{W,n}$, $P_{W,n}$, $G_{W,n}$) diejenigen Werte der Bondkraft $F_W$, der Ultraschallgrösse $P_W$ und des gegebenenfalls mindestens einen weiteren Bondparameters $G_W$ als optimale Bondparameter bestimmt werden, für die der Strom $I_{n,max}$ ($F_{W,n}$, $P_{W,n}$, $G_{W,n}$) ein Maximum erreicht.

Fig. 1A

Fig. 1B

Fig. 1C

Fig. 1E

Fig. 1F

Fig. 2A                 Fig. 2B                 Fig. 2C                 Fig. 2D

Fig. 3A                 Fig. 3B                 Fig. 3C                 Fig. 3D

**Europäisches Patentamt**

## EUROPÄISCHER RECHERCHENBERICHT

Nummer der Anmeldung

EP 02 07 9593

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 5 302 550 A (HIROTA JITSUHO ET AL) 12. April 1994 (1994-04-12) * das ganze Dokument * --- | 1,2 | B23K20/00 H01L21/66 |
| A | EP 0 772 036 A (STAUDINGER GEROLD) 7. Mai 1997 (1997-05-07) * das ganze Dokument * --- | 1,2 | |
| A | ROONEY D T ET AL: "EVALUATION OF WIRE BOND QUALITY BY SEM ANALYSIS OF BALL-SHAPE AND VISUAL INSPECTION OF INTERMETALLIC FORMATION" , INTERNATIONAL JOURNAL OF MICROCIRCUITS AND ELECTRONIC PACKAGING, INTERNATIONAL MICROELECTRONICS & PACKAGING SOCIETY, US, VOL. 20, NR. 2, PAGE(S) 138-149 XP000696069 ISSN: 1063-1674 * das ganze Dokument * --- | 1,2 | |
| A | BOCHAROV M I ET AL: "AN AMPLITUDE MODULATOR BASED ON SYNTHESIZED NONLINEAR REACTIVE COMPONENTS" , TELECOMMUNICATIONS AND RADIO ENGINEERING, BEGELL HOUSE, INC., NEW YORK, NY, US, VOL. 43, NR. 6, PAGE(S) 68-71 XP000108784 ISSN: 0040-2508 * das ganze Dokument * --- -/-- | 1,2 | RECHERCHIERTE SACHGEBIETE (Int.Cl.7) B23K H01L G01N |

Der vorliegende Recherchenbericht wurde für alle Patentansprüche erstellt

| Recherchenort | Abschlußdatum der Recherche | Prüfer |
|---|---|---|
| MÜNCHEN | 31. März 2003 | De Backer, T |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

EP 1 419 845 A1

| Europäisches Patentamt | **EUROPÄISCHER RECHERCHENBERICHT** | Nummer der Anmeldung EP 02 07 9593 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | AGUILA MA M T ET AL: "Ball bond characterization: an intensive analysis on ball size and shear test results and applicability to existing standards", ELECTRONIC PACKAGING TECHNOLOGY CONFERENCE, 1997. PROCEEDINGS OF THE 1997 1ST SINGAPORE 8-10 OCT. 1997, NEW YORK, NY, USA,IEEE, US, PAGE(S) 46-51 XP010310021 ISBN: 0-7803-4157-0 * das ganze Dokument * | 1,2 | |

RECHERCHIERTE SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| MÜNCHEN | 31. März 2003 | De Backer, T |

## ANHANG ZUM EUROPÄISCHEN RECHERCHENBERICHT
## ÜBER DIE EUROPÄISCHE PATENTANMELDUNG NR.

EP 02 07 9593

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-03-2003

| Im Recherchenbericht angeführtes Patentdokument | | Datum der Veröffentlichung | Mitglied(er) der Patentfamilie | | Datum der Veröffentlichung |
|---|---|---|---|---|---|
| US 5302550 | A | 12-04-1994 | JP | 62174936 A | 31-07-1987 |
| | | | JP | 62174930 A | 31-07-1987 |
| | | | JP | 62150729 A | 04-07-1987 |
| | | | JP | 62150730 A | 04-07-1987 |
| | | | DE | 3641688 A1 | 02-07-1987 |
| | | | DE | 3641689 A1 | 25-06-1987 |
| EP 0772036 | A | 07-05-1997 | NL | 1001532 C1 | 02-05-1997 |
| | | | EP | 0772036 A2 | 07-05-1997 |

Für nähere Einzelheiten zu diesem Anhang : siehe Amtsblatt des Europäischen Patentamts, Nr.12/82

EPO FORM P0461